(19) Europäisches Patentamt / European Patent Office / Office européen des brevets

(11) **EP 4 305 434 B1**

(12) **EUROPÄISCHE PATENTSCHRIFT**

(45) Veröffentlichungstag und Bekanntmachung des Hinweises auf die Patenterteilung:
**21.01.2026   Patentblatt 2026/04**

(21) Anmeldenummer: **22712559.8**

(22) Anmeldetag: **09.03.2022**

(51) Internationale Patentklassifikation (IPC):
**G01R 31/367** $^{(2019.01)}$     **G01R 31/392** $^{(2019.01)}$

(52) Gemeinsame Patentklassifikation (CPC):
**G01R 31/392; G01R 31/367;** G01R 31/3842

(86) Internationale Anmeldenummer:
**PCT/EP2022/056015**

(87) Internationale Veröffentlichungsnummer:
**WO 2022/189494 (15.09.2022 Gazette 2022/37)**

(54) **ABSCHÄTZUNG VON KENNGRÖSSEN BEI WIEDERAUFLADBAREN BATTERIEN**

ESTIMATING CHARACTERISTIC VALUES IN RECHARGEABLE BATTERIES

ESTIMATION DE GRANDEURS CARACTÉRISTIQUES DANS DES BATTERIES RECHARGEABLES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität:  **10.03.2021   DE 102021105784**

(43) Veröffentlichungstag der Anmeldung:
**17.01.2024   Patentblatt 2024/03**

(73) Patentinhaber: **TWAICE Technologies GmbH 80807 München (DE)**

(72) Erfinder:
• **BERG, Philipp 81827 München (DE)**
• **KARGER, Alexander 81667 München (DE)**

(74) Vertreter: **Kraus & Lederer PartGmbB Thomas-Wimmer-Ring 15 80539 München (DE)**

(56) Entgegenhaltungen:
EP-A1- 3 916 884          WO-A1-2019/240270
WO-A1-2020/152901     WO-A1-2020/262655
CN-B- 103 176 139        DE-A1- 102010 051 008
DE-A1- 102013 000 572   DE-A1- 102016 209 852
DE-T5- 112019 003 028   US-A1- 2022 115 890

**Beschreibung**

TECHNISCHES GEBIET

Verschiedene Beispiele der Offenbarung betreffen Techniken, um Abschätzungen für ein oder mehrere charakteristische Kenngrößen einer wiederaufladbaren Batterie zu bestimmen. Insbesondere kann eine Abschätzung für die Leerlaufspannung oder die Kapazität einer wiederaufladbaren Batterie bestimmt werden.

HINTERGRUND

Wiederaufladbare Batterien altern als Funktion der Zeit sowie als Funktion der Ladezyklen. Das bedeutet, dass für zunehmende Alterung beispielsweise die Kapazität einer wiederaufladbaren Batterie abnimmt.

Für viele wiederaufladbare Batterien stellt die Leerlaufspannung-Ladungszustands-Kennlinie eine charakteristische Kenngröße dar. Die Leerlaufspannung-Ladungszustands-Kennlinie wird auch einfach als Ruhespannungskennlinie bezeichnet.

Bei der Ruhespannungskennlinie wird die Leerlaufspannung (wird auch als Ruhespannung bezeichnet) der Batterie als Funktion des Ladungszustands, das heißt zum Beispiel der verfügbaren Ladung als Bruchteil der Kapazität, beschrieben.

Die WO 2020/152901 A1 betrifft ein Verfahren zur Diagnose der Restlebensdauer von Sekundärbatteriemodulen. Dieses Diagnoseverfahren umfasst die folgenden Schritte: Erfassen von Ladeinformationen einschließlich des Stroms, der Spannung und des Ladezustands eines Sekundärbatteriemoduls; Erhalten der aktuellen Kapazität und des Innenwiderstands des Sekundärbatteriemoduls aus den Ladeinformationen; Berechnen eines Grads der Verschlechterung des Sekundärbatteriemoduls durch Vergleichen der erhaltenen Kapazität und des Innenwiderstands mit den Anfangswerten der Kapazität und des Innenwiderstands; und Festlegen dieses Grads der Verschlechterung als einen Messwert; Erfassen von Ausgangsinformationen des sekundären Batteriemoduls; Berechnen, unter Verwendung der Ausgangsinformationen, eines vorhergesagten Wertes des Grades der Verschlechterung durch eine Vorhersageformel; Vergleichen des gemessenen Wertes mit dem vorhergesagten Wert; und Berechnen der verbleibenden Lebensdauer, wenn die Differenz zwischen dem gemessenen Wert und dem vorhergesagten Wert kleiner oder gleich einem vorbestimmten Wert ist.

Die DE 10 2013 000 572 A1 betrifft ein Verfahren zur Bestimmung der Modellparameter eines elektrochemischen Energiespeichers, dessen dynamisches Verhalten im Betrieb durch ein elektrisches Referenzmodell beschrieben wird. Das Referenzmodell umfasst zumindest eine Kapazität und einen damit verbundenen ersten Widerstand, die Parameter des Referenzmodells sind. Die Parameterwerte der Parameter bilden gemeinsam einen Parameterdatensatz und werden während des Betriebes des Energiespeichers an dessen aktuellen Zustand angepasst. Hierfür werden ausgehend von einem Referenzparameterdatensatz eine Mehrzahl an Parameterdatensatzvarianten gebildet, für die jeweils iterativ anhand des aktuellen, gemessenen Stroms des Energiespeichers die Überspannung sowie daraus eine Abweichung der Summe dieser Überspannung und einer Anfangsspannung zur aktuell gemessenen Spannung ermittelt und aufintegriert wird. Anschließend wird bestimmt, welcher Parameterdatensatzvariante die kleinste quadratische Abweichung zugeordnet ist. Diese Parameterdatensatzvariante wird dann als neuer Referenzdatensatz zur Beschreibung des Batteriemodells definiert und kann zur prädikativen Bestimmung der für eine vordefinierte Zeit zur Verfügung stehenden, maximalen Leistung des Energiespeichers verwendet werden.

Die WO 2020/262655 A1 betrifft eine Sekundärbatteriesteuerungsvorrichtung, die eine Steuereinheit zum Korrigieren von Batterieeigenschaften umfasst, die sich auf Leerlaufspannungen in Bezug auf die Restkapazitäten einer Sekundärbatterie beziehen. In der Sekundärbatteriesteuerungsvorrichtung erfasst die Steuereinheit mehrere Leerlaufspannungsdaten für die Batterieeigenschaften während des Ladens der Sekundärbatterie, korrigiert die Leerlaufspannungen zwischen jedem der Datenpaare in mindestens einigen Kombinationen unter den mehreren Leerlaufspannungsdaten, wenn die Sekundärbatterie vollständig geladen ist, und korrigiert die volle Ladekapazität, die aus der Korrektur der Leerlaufspannungen zwischen jedem der Datenpaare berechnet wird, unter Verwendung einer gewichteten Mittelwertbildung mit der Differenz der entsprechenden Restkapazitäten zwischen jedem der Datenpaare.

Die WO 2019/240270 A1 betrifft eine Vorrichtung zur Schätzung einer Lade-/Entladekurve. Die Vorrichtung leitet eine Näherungskurve für eine anfängliche Impedanzfunktion und eine anfängliche Leerlaufspannungsfunktion als anfängliches Korrektur-Objekt ab und setzt die Näherungskurve als Vorausschätzungsfunktion ein. Nach dem Start des Lade-/Entladevorgangs misst eine Messeinheit eine Lade-/Entladespannung und einen Lade-/Entladestrom in einem festgelegten Zeitraum. Eine SOC-Berechnungseinheit berechnet gleichzeitig mit der Messung der Lade-/Entladespannung einen SOC-Wert.

Die DE 10 2010 051 008 A1 betrifft eine Steuereinrichtung für einen Elektroantrieb für ein Fahrzeug, wobei der Elektroantrieb als Komponenten zumindest einen DC-DC-Wandler, einen Elektromotor und eine Batterie umfasst. Die Steuereinrichtung ist so ausgelegt, dass zumindest eine relevante Kenngröße oder zumindest eine relevante Veränderung einer Kenngröße der Batterie dadurch bestimmt wird, dass die Komponenten des Elektroantriebs geeignet angesteuert werden.

Die DE 10 2016 209 852 A1 betrifft ein Verfahren zum Abschätzen einer Kapazität eines Batteriesystems und/oder einer einzelnen Zelle und/oder eines Satzes, der in einem Fahrzeug beinhaltet ist. Das Verfahren kann das Bestimmen von spannungsbasierten Ladezustands-("SOC")-Daten eines Satzes des Batteriesystems basierend auf gemessenen Satzspannungsinformationen und einer Beziehung zwischen einer Leerlaufspannung ("OCV") und dem SOC des Satzes bei einem Beginn der Lebensdauer des Satzes umfassen. Beginn-der-Lebensdauer-SOC-Daten des Satzes können basierend auf Amperesekundenzählungsmessungen bestimmt werden und ein Verhältnis kann basierend auf den Beginn-der-Lebensdauer-SOC-Daten des Satzes und den spannungsbasierten SOC-Daten des Satzes bestimmt werden. Eine abgeschätzte gegenwärtige Kapazität des Satzes kann basierend auf der Beginn-der-Lebensdauer-Kapazität des Satzes und dem Verhältnis bestimmt werden.

ZUSAMMENFASSUNG

Es besteht ein Bedarf an verbesserten Techniken, um für verschiedene charakteristische Kenngrößen einer Batterie - z.B. Ruhespannung, Ladungszustand, Kapazität, Ruhespannungskennlinie - zuverlässige Abschätzungen zu bestimmen.

Diese Aufgabe wird gelöst von den Merkmalen des unabhängigen Patentanspruchs. Die Merkmale der abhängigen Patentansprüche definieren Ausführungsformen.

Ein Verfahren umfasst das Empfangen einer Zeitreihe von Strom-Spannung-Wertepaaren für einen Strom und eine Spannung einer Batterie im Feldbetrieb. Das Verfahren umfasst auch, unter Verwendung von ein oder mehreren Filterkriterien, das Filtern der Zeitreihe der Strom-Spannung-Wertepaare, um derart eine Teilmenge der Strom-Spannung-Wertepaare zu erhalten. Ferner umfasst das Verfahren das Bestimmen von ein oder mehreren Abschätzungen einer Ruhespannung der Batterie basierend auf den Strom-Spannung-Wertepaaren in der Teilmenge.

Ein Filterkriterium umfasst ein Verhältnis zwischen einer Magnitude einer zeitlichen Änderung des Stroms und einer zeitgemittelten und/oder instantanen Magnitude des Stroms.

Ein Computerprogramm oder ein Computerprogramm-Produkt oder ein computerlesbares Speichermedium umfasst Programmcode, der von einem Prozessor geladen und ausgeführt werden kann. Das bewirkt, dass der Prozessor ein Verfahren ausführt. Das Verfahren umfasst das Empfangen einer Zeitreihe von Strom-Spannung-Wertepaaren für einen Strom und eine Spannung einer Batterie im Feldbetrieb. Das Verfahren umfasst auch, unter Verwendung von ein oder mehreren Filterkriterien, das Filtern der Zeitreihe der Strom-Spannung-Wertepaare, um derart eine Teilmenge der Strom-Spannung-Wertepaare zu erhalten. Ferner umfasst das Verfahren das Bestimmen von ein oder mehreren Abschätzungen einer Ruhespannung der Batterie basierend auf den Strom-Spannung-Wertepaaren in der Teilmenge.

Ein Gerät umfasst einen Prozessor und einen Speicher. Der Prozessor kann Programmcode vom Speicher laden und ausführen. Das bewirkt, dass der Prozessor ein Verfahren ausführt. Das Verfahren umfasst das Empfangen einer Zeitreihe von Strom-Spannung-Wertepaaren für einen Strom und eine Spannung einer Batterie im Feldbetrieb. Das Verfahren umfasst auch, unter Verwendung von ein oder mehreren Filterkriterien, das Filtern der Zeitreihe der Strom-Spannung-Wertepaare, um derart eine Teilmenge der Strom-Spannung-Wertepaare zu erhalten. Ferner umfasst das Verfahren das Bestimmen von ein oder mehreren Abschätzungen einer Ruhespannung der Batterie basierend auf den Strom-Spannung-Wertepaaren in der Teilmenge.

Die oben dargelegten Merkmale und Merkmale, die nachfolgend beschrieben werden, können nicht nur in den entsprechenden explizit dargelegten Kombinationen verwendet werden, sondern auch in weiteren Kombinationen oder isoliert, ohne den Schutzumfang der vorliegenden Erfindung zu verlassen.

KURZE BESCHREIBUNG DER FIGUREN

FIG. 1 illustriert schematisch ein System umfassend ein Ensemble aus mehreren Batterien und einen Server.

FIG. 2 illustriert schematisch eine Batterie gemäß verschiedenen Beispielen.

FIG. 3 illustriert schematisch einen Server gemäß verschiedenen Beispielen.

FIG. 4 illustriert schematisch mehrere Ruhespannungskennlinien für unterschiedliche Alterungszustände einer Batterie gemäß verschiedenen Beispielen.

FIG. 5 ist ein Flussdiagramm eines beispielhaften Verfahrens.

FIG. 6 ist ein Flussdiagramm eines beispielhaften Verfahrens.

FIG. 7 illustriert eine Zeitreihe von Strom-Spannung-Wertepaaren gemäß verschiedenen Beispielen.

FIG. 8 ist ein Flussdiagramm eines beispielhaften Verfahrens.

## DETAILLIERTE BESCHREIBUNG VON AUSFÜHRUNGSFORMEN

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Nachfolgend wird die vorliegende Erfindung anhand bevorzugter Ausführungsformen unter Bezugnahme auf die Zeichnungen näher erläutert. In den Figuren bezeichnen gleiche Bezugszeichen gleiche oder ähnliche Elemente. Die Figuren sind schematische Repräsentationen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und genereller Zweck dem Fachmann verständlich wird. In den Figuren dargestellte Verbindungen und Kopplungen zwischen funktionellen Einheiten und Elementen können auch als indirekte Verbindung oder Kopplung implementiert werden. Eine Verbindung oder Kopplung kann drahtgebunden oder drahtlos implementiert sein. Funktionale Einheiten können als Hardware, Software oder eine Kombination aus Hardware und Software implementiert werden.

Nachfolgend werden verschiedene Techniken beschrieben, die es ermöglichen, ein oder mehrere charakteristische Kenngrößen für wiederaufladbare Batterien (nachfolgend einfach als Batterien bezeichnet) zu bestimmen. Solche charakteristischen Kenngrößen können versteckte Parameter der Batterie darstellen, weil sie - zumindest im Feldbetrieb der Batterie - nicht direkt gemessen werden können. Nachfolgend werden einige Beispiele für charakteristische Kenngrößen, die gemäß den hierin beschriebenen Techniken bestimmt werden können, beschrieben.

TAB. 1: Verschiedene Beispiele für charakteristische Kenngrößen einer Batterie, die im Zusammenhang mit den hierin beschriebenen Beispielen abgeschätzt werden können.

| Kenngröße | Beispielhafte Details |
|---|---|
| Ruhespannung | Beispielsweise können Abschätzungen für die Ruhespannung einer Batterie bestimmt werden. Dabei bezeichnet die Ruhespannung (auch als Leerlaufspannung bezeichnet; engl. open circuit voltage, OCV) diejenige Spannung, die zwischen den Klemmen der Batterie (Pluspol und Minuspol) anliegt, wenn die Klemmen offen sind (lastfrei), das heißt nicht miteinander (zum Beispiel über eine Last) verbunden sind. Das bedeutet, dass zwischen den Klemmen der Batterie kein Strom fließt. |
| | Typischerweise ist es für Batterien im Feldbetrieb - die zum Beispiel in einem Elektrofahrzeug eingebaut sind oder allgemein einen Verbraucher versorgen - nicht oder nur eingeschränkt möglich, die Ruhespannung direkt zu messen. Dies liegt daran, dass es nicht oder nur selten vorkommt, dass die Batterie lastfrei ist. Die Ruhespannung ist also ein sog. versteckter Parameter der Batterie, der nicht direkt gemessen werden kann, aber aus anderen Größen abgeleitet werden kann. |
| | Es sind Referenztechniken bekannt, um die Ruhespannung einer Batterie in speziellen Kalibrationsphasen, manchmal als Check-up-Zyklen bezeichnet, zu bestimmen. Siehe zum Beispiel Petzl, Mathias, and Michael A. Danzer. "Advancements in OCV measurement and analysis for lithium-ion batteries." IEEE Transactions on energy conversion 28.3 (2013): 675-681. Solche Techniken weisen den Nachteil auf, dass eine Unterbrechung des Normalbetriebs für eine Kalibrationsphase oftmals nicht möglich ist. Deshalb sind solche Techniken von begrenzter Relevanz für viele Anwendungsszenarien. |
| | Gemäß verschiedenen Beispielen ist es möglich, eine Abschätzung für die Ruhe-spannung zu bestimmen. |

(fortgesetzt)

| Kenngröße | Beispielhafte Details |
|---|---|
| | Techniken, um die Ruhespannung zu bestimmen werden nachfolgend unter anderem im Zusammenhang mit TAB. 4 beschrieben. |
| Ladungszustand | Der Ladungszustand indiziert die verfügbare Ladung der Batterie bezogen auf den Zustand voller Ladung, das heißt bezogen auf die Kapazität. Zum Beispiel kann 0 % einen total entladenen Zustand beschreiben und 100 % einen vollgeladenen Zustand bezeichnen. |
| | In den hierin beschriebenen Techniken können unterschiedliche Techniken zur Abschätzung des Ladungszustands verwendet werden. |
| | Beispielsweise kann der Ladungszustand Spannungs-basiert bestimmt werden ($SOC_V$). Dazu kann eine beliebige Ruhespannung verwendet werden und über die Ruhespannungskennlinie (siehe unten) kann dann auf den Ladungszustand zurückgeschlossen werden ("Nachschlagen"). |
| | Eine weitere Abschätzung des Ladungszustands wird Ladungs-basiert erhalten ($SOC_C$). Das sogenannte Coulomb-Zählen kann eingesetzt werden, das heißt der Stromfluss kann über der Zeit integriert werden und dann kann die derart gemessene Ladung in Bezug gesetzt werden zu einer derzeit gültigen (a-priori) Abschätzung der Kapazität der Batterie. |
| Ruhespannungskennlinie | Eine weitere charakteristische Kenngröße betrifft die Ruhespannungskennlinie der Batterie. Die Ruhespannungskennlinie kann die Ruhespannung für mehrere Ladungszustände (engl. state of charge, SOC) der Batterie beschreiben. Die Ruhespannungskennlinie wird deshalb auch manchmal als SOC-OCV-Kennlinie bezeichnet. Die Ruhespannung nimmt typischerweise monoton als Funktion des Ladungszustands zu. |
| | In manchen Varianten wäre es möglich, mehrere Ruhespannungskennlinien zu bestimmen, nämlich für mehrere Betriebsparameter der Batterie wie beispielsweise Temperatur der Batterie. |
| | Es wäre auch möglich, mehrere Ruhespannungskennlinien unter Berücksichtigung der Hysterese der Ruhespannung zu bestimmen, also jeweils eine Ruhespannungskennlinie basierend auf Strom-Spannung-Wertepaaren, die Ladevorgängen zugeordnet sind, und basierend auf Strom-Spannung-Wertepaaren, die Entladevorgängen zugeordnet sind. Es wäre möglich, diese beiden Ruhespannungskennlinien - z.B. unter Berücksichtigung eines Offsets, der durch den Hysterese-Effekt bestimmt wird, miteinander zu kombinieren. |
| | Die Ruhespannungskennlinie ist (beispielsweise alternativ oder zusätzlich zu Werten der Impedanz der Batterie) eine aussagekräftige Kenngröße für elektrische Modelle der Batterie. Solche elektrischen Modelle, etwa ein Ersatzschaltkreismodell wie das sog. Rint-Modell oder das Thevenin-Modell, können zum Beispiel verwendet werden, um den Ladungszustand der Batterie zu bestimmen. Beispielsweise kann ein Kalman-Filter verwendet werden, um solche versteckten Eigenschaften der Batterie zu bestimmen. Der Kalman-Filter kann zufälliges Rauschen unterdrücken. |
| | Die Ruhespannungskennlinie kann auch zur Vorhersage von Alterungswerten in der Zukunft (unter Annahme eines bestimmten Betriebsprofils der Batterie) verwendet werden. |

| Kenngröße | Beispielhafte Details |
|---|---|
|  | Ein weiteres Anwendungsgebiet für die Ruhespannungskennlinie betrifft die sogenannte differentielle Spannungsanalyse. Dabei kann die Ableitung der Ruhespannungskennlinie nach dem Ladungszustand bestimmt werden und in Abhängigkeit davon können verschiedene Degradationsmechanismen der Batterie, die zu einer Alterung führen, quantifiziert werden. Beispiele für solche Degradationsmechanismen betreffen zum Beispiel den Verlust von Lithium oder den Verlust von Aktivmaterial.<br><br>Im Labor kann gemäß Referenztechniken die Ruhespannungskennlinie direkt gemessen werden, beispielsweise indem eine schrittweise Entladung der Batterie in kleinen Inkrementen (zum Beispiel 1 % Ladungszustand-Schritte) mit anschließender Relaxation für einige Zeit verwendet werden. Eine solche Messmethode wird als stationäre Messung bezeichnet. Eine andere Variante betrifft eine langsame kontinuierliche Entladung, zum Beispiel mit C/50 (die C-Rate ist definiert in Bezug auf die Kapazität, wobei z.B. 1C bedeutet, dass die Batterie binnen einer Stunde entladen wird). Die Ruhespannungskennlinie kann im Feldbetrieb ein versteckter Parameter der Batterie sein, genauso wie die Ruhespannung selbst, wie obenstehend beschrieben.<br><br>Eine weitere Referenztechnik betrifft die Parametrisierung der Ruhespannung im Betrieb. Siehe z.B. Zhang, Caiping, et al. "A generalized SOC-OCV model for lithium-ion batteries and the SOC estimation for LNMCO battery." Energies 9.11 (2016): 900. Entsprechende Techniken sind auch beschrieben in: Tong, Shijie, Matthew P. Klein, and Jae Wan Park. "On-line optimization of battery open circuit voltage for improved state-of-charge and state-of-health estimation." Journal of Power Sources 293 (2015): 416-428. Solche Techniken weisen den Nachteil auf, dass für ihre Anwendung immer eine a-priori Abschätzung einer Ruhespannungskennlinie vorausgesetzt wird, die dann in einem iterativen Verfahren angepasst wird.<br><br>Es gibt auch Referenztechniken, um die Ruhespannungskennlinie im Rahmen von datenbasierten Ansätzen zu bestimmen. Dabei wird überwacht, ob die Spannung zu einem bestimmten Zeitpunkt als relaxiert angenommen werden kann. Solche Techniken sind zum Beispiel beschrieben in Chen, Xiaokai, et al. "A novel approach to reconstruct open circuit voltage for state of charge estimation of lithium ion batteries in electric vehicles." Applied Energy 255 (2019): 113758. Solche Techniken sind auch beschrieben in Tong, Shijie, Matthew P. Klein, and Jae Wan Park. "On-line optimization of battery open circuit voltage for improved state-of-charge and state-of-health estimation." Journal of Power Sources 293 (2015): 416-428. Ferner sind solche Techniken beschrieben in: Xiong, Rui, Quanqing Yu, and Cheng Lin. "A novel method to obtain the open circuit voltage for the state of charge of lithium ion batteries in electric vehicles by using H infinity filter." Applied energy 207 (2017): 346-353.<br><br>Verschiedene Beispiele beruhen auf der Erkenntnis, dass die Ruhespannungskennlinie eine Abhängigkeit vom Alterungszustand der Batterie aufweist. Beispielsweise verändert sich der Absolutwert der Ruhespannung in Abhängigkeit von der Kapazität der Batterie. Oftmals wird z.B. beobachtet, dass für Ladungszustände im Bereich von ca. 40% bis 60% die Ruhespannung mit zunehmender Alterung zunimmt. Außerdem verändert sich oftmals die Form der Ruhespannungskennlinie. Zum Beispiel könnte die Ruhespannungskennlinie insbesondere für kleine Ladungszustände stärker abknicken. |

(fortgesetzt)

| Kenngröße | Beispielhafte Details |
|---|---|
| | Eine solche Abhängigkeit der Ruhespannungskennlinie vom Alterungszustand der Batterie kann bewirken, dass die Bestimmung von charakteristischen Kenngrößen auf Grundlage der Ruhespannungskennlinie für zunehmende Alterung der Batterie ungenauer wird. Insbesondere kann dies dann auftreten, wenn a-priori-Wissen im Zusammenhang mit der Ruhespannungskennlinie eine fixe Ruhespannungskennlinie unabhängig vom Alterungszustand der Batterie annimmt. Zum Beispiel wurden Szenarien beobachtet, bei denen eine Kalman-basierte Bestimmung des Ladungszustands unter Verwendung der Ruhespannungskennlinie mit zunehmender Alterung der Batterie immer ungenauer wird. Deshalb kann in den verschiedenen hierin beschriebenen Beispielen eine Abschätzung der Ruhespannungskennlinie während des Betriebs der Batterie wiederholt bestimmt werden.<br><br>Verschiedene Techniken ermöglichen es, die Ruhespannungskennlinie zu bestimmen. Entsprechende Techniken werden zum Beispiel nachfolgend im Zusammenhang mit Box 3105 aus Fig. 8 beschrieben. |
| Kapazität | Eine weitere charakteristische Kenngröße betrifft die Kapazität der Batterie. Die Kapazität beschreibt die verfügbare Ladung im komplett geladenen Zustand. Insbesondere kann es gemäß den verschiedenen hierin beschriebenen Beispielen möglich sein, basierend auf der Ruhespannungskennlinie die Kapazität der Batterie zu bestimmen. Dies kann auf der Bestimmung des Ladungszustands basieren, d.h. als Abwandlung einer Coulomb-Zähltechnik mit linearer Interpolation auf 100%-SOC. Entsprechende Techniken werden beschrieben im Zusammenhang mit FIG. 8: Box 3120.<br><br>Verschiedene Beispiele beruhen auf der Erkenntnis, dass eine herabgesetzte Genauigkeit der Bestimmung des Ladungszustands zum Beispiel mittels Coulomb-Zählen (aufgrund einer herabgesetzten Genauigkeit der a-priori Abschätzung der Kapazität, etwa aufgrund von Alterung) wiederum in einer reduzierten Genauigkeit bei der Bestimmung der Kapazität basierend auf dem Ladungszustand resultieren kann. Deshalb kann gemäß den verschiedenen hierin beschriebenen Techniken eine Neubestimmung der Abschätzung der Kapazität (a-posteriori Abschätzung) von Zeit zu Zeit angestoßen werden, nämlich wenn ein oder mehrere Auslösekriterien eintreten. |

In den verschiedenen Beispielen können charakteristische Kenngrößen für unterschiedliche Batterien verwendet werden. Zum Beispiel können Lithium-Ionen-Batterien verwendet werden. Es können aber auch Batterien mit anderen Elektrolyten verwendet werden. Es könnten Z.B. NiMH Batterien berücksichtigt werden. Die Batterien können unterschiedliche Gehäuseformen aufweisen, usw. Die Batterien können in unterschiedlichen Anwendungsszenarien eingesetzt sein. Beispielsweise können die Batterie als Antriebsbatterie für ein Elektrofahrzeug, etwa ein Auto oder einen E-Scooter, eingesetzt werden. Die Batterien könnten auch als stationäre Energiespeicher, zum Beispiel in einem Mikrostromnetz oder zur Netzstabilisierung in einem Makrostromnetz, verwendet werden.

Gemäß verschiedenen Beispielen kann eine Zeitreihe von Strom-Spannung-Wertepaaren für Strom und Spannung der Batterie im Feldbetrieb empfangen werden. Das bedeutet, dass eine Zeitabfolge von Stromwerten und Spannungswerten erhalten werden kann. Sofern die Stromwerte und die Spannungswerte an unterschiedlichen Zeitpunkten gemessen wurden, ist es möglich, eine Interpolation auf ein gemeinsames Zeitraster durchzuführen.

Daraus können Abschätzungen für ein oder mehrere charakteristische Kenngrößen der Batterie durch Anwendung von ein oder mehreren computerimplementierten Algorithmen bestimmt werden. Insbesondere ist es möglich, mehrere Abschätzungen für die Ruhespannung zu bestimmen, nämlich bei unterschiedlichen Ladungszuständen der Batterie. Die Ladungszustände können mittels Coulomb-Zählen bestimmt werden (SOCc). Basierend auf diesen Abschätzungen der Ruhespannung ist es dann möglich, eine Abschätzung für die Ruhespannungskennlinie zu bestimmen. Basierend auf der Abschätzung für die Ruhespannungskennlinie kann dann wiederum eine Abschätzung für die Kapazität der Batterie bestimmt werden.

In einem Beispiel wird die Zeitreihe von Strom-Spannung-Wertepaaren initial gefiltert, unter Verwendung von ein oder mehreren Filterkriterien. Derart kann eine Teilmenge der Strom-Spannung-Wertepaare erhalten werden. Basierend auf den Strom-Spannung-Wertepaaren in der Teilmenge können dann ein oder mehrere Abschätzungen der Ruhespannung der Batterie bestimmt werden.

Solche Techniken beruhen auf der Erkenntnis, dass nicht alle Strom-Spannung-Wertepaare gleich gut geeignet sind, um für die Bestimmung der Ruhespannung herangezogen zu werden. Insbesondere sollten solche Strom-Spannung-Wertepaare verwendet werden, die einerseits einem möglichst relaxierten Zustand der Batterie entsprechen, andererseits auch besonders gutes Signal-zu-Rausch-Verhältnis bei der Bestimmung der Abschätzung für die Ruhespannung ermöglichen.

Verschiedene beispielhafte Filterkriterien, die einzeln oder auch kumulativ eingesetzt werden können, sind nachfolgenden TAB. 2 zusammengefasst. Dabei werden folgende Parameter verwendet:

Strom:$I$ (wobei in der nachfolgenden Notation gilt: I>0 für einen Ladevorgang und I<0 für einen Entladevorgang)

Spannung: $U$

zeitliche Änderung des Stroms: d$I$

zeitliche Änderung der Spannung: d$U$

Differentieller Widerstand: d$R$ = d$U$/d$I$

Anzahl seriell geschalteter Batteriezellen: $s$

Strom geflossen in den 10 davorliegenden Sekunden $pI10s$. Das bedeutet: $pI10s$ = Mittelwert($|I|_{\text{letzte 10 Sekunden}}$). Dabei beträgt das Zeitmittelungsintervall nur beispielhaft 10 Sekunden und könnte auch länger oder kürzer gewählt sein. Es wurde beobachtet, dass Zeitmittelungsintervalle im Bereich von ca. 1 bis 30 Sekunden für typische Betriebsprofile von Batterien relevante Werte liefern können.

Es wäre auch möglich, dass das Zeitmittelungsintervall in Abhängigkeit von der Temperatur gewählt wird. Dies beruht auf der Erkenntnis, dass unterschiedliche Temperaturen unterschiedliche Relaxationsgeschwindigkeiten für die Ruhespannung zur Folge haben können.

C-Rate: $C$, d.h. Strom bezogen auf die Kapazität der Zelle $C$

Laufindex k. $k$ indiziert die verschiedenen Strom-Spannung-Wertepaare der Zeitreihe.

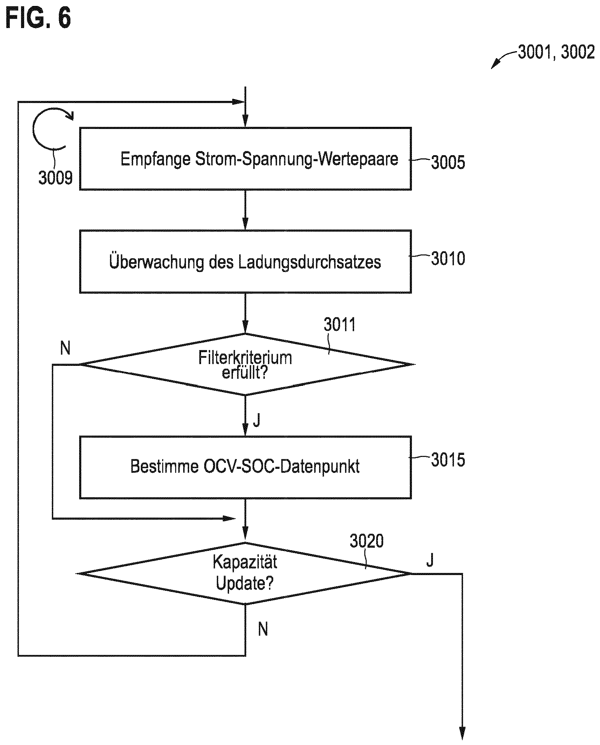

TAB. 2: Beispiele für Filterkriterien, mittels derer Strom-Spannung-Wertepaare aus einer entsprechenden Zeitreihe selektiert werden können. Diese selektierten Strom-Spannung-Wertepaare können dann dazu verwendet werden, um ein oder mehrere Abschätzungen für die Ruhespannung der Batterie zu bestimmen. In den beschriebenen Beispielen werden insbesondere mehrere Filterkriterien miteinander verknüpft. Z.B. kann ein Strom-Spannung-Wertepaar dann selektiert werden, wenn kumulativ alle Filterkriterien des Beispiels I erfüllt werden, ein Strom-Spannung-Wertepaar kann auch dann selektiert werden, wenn kumulativ alle Filterkriterien des Beispiels II erfüllt werden, ein Strom-Spannung-Wertepaar kann auch dann selektiert werden, wenn kumulativ alle Filterkriterien des Beispiels III erfüllt werden. D.h. ein Datenpunkt k wird ausgewählt, wenn die kombinierten Filterkriterien gemäß Beispiel I erfüllt sind oder wenn die kombinierten Filterkriterien gemäß Beispiel II erfüllt sind oder wenn die kombinierten Filterkriterien gemäß Beispiel III erfüllt sind. Es wären aber auch andere logische Kombinationen von Filterkriterien möglich. Es können auch weitere Filterkriterien definiert werden. Beispielsweise könnte für einige oder alle Beispiele I-III als weiteres Filterkriterium im jeweiligen kombinierten Filterkriterium gefordert werden, dass $dR(k) > 0$, d.h. positive differentielle Widerstände. Derart können Rauschen und Messungenauigkeiten, die in offensichtlich fehlerhaften Datenpunkten resultieren, gefiltert werden. Als weiteres Beispiel können rein empirische Filterkriterien definiert werden. Beispielsweise wurde festgestellt, dass eine Verknüpfung der folgenden Filterkriterien Strom-Spannung-Wertepaare selektiert, welche eine genaue Abschätzung für die Ruhespannung ermöglichen: $(|dI(k)| > C)$ & $(|I(k)| < C)$ & $(pI10s(k) < C)$ & $(dR(k) > 0)$. Beispielsweise können solche Filterkriterien in Box 3011 des Verfahrens der FIG. 6 eingesetzt werden.

| | Kurze Beschreibung | Beispielhafte Details |
|---|---|---|
| I | Relaxierte Spannung | $|dU(k)| < s * 0.01V$ & $|I(k)| < s * 0.01A$ |

(fortgesetzt)

|  | Kurze Beschreibung | Beispielhafte Details |
|---|---|---|
|  |  | Ein solches kombiniertes Filterkriterium selektiert Strom-Spannung-Wertepaare, die eine geringe Spannungsänderung bei gleichzeitig kleinem Strom betreffen. Dies ist ein Indikator für eine relaxierte Spannung. |
|  |  | Allgemein formuliert kann ein Filterkriterium verwendet werden, das ein Verhältnis zwischen einer zeitlichen Änderung der Spannung und der Spannung umfasst (erster Term der Gleichung oben). Es kann insbesondere die Magnitude der zeitlichen Änderung betrachtet werden. |
|  |  | Das Verhältnis ist im Beispiel durch den Faktor 0.01 quantifiziert, aber es sind auch andere Verhältnisse denkbar. |
|  |  | Durch dieses Verhältnis kann vermieden werden, dass solche Strom-Spannung-Wertepaare selektiert werden, die einer instabilen, schwankenden Spannung entsprechen. |
|  |  | Ein weiteres Filterkriterium kann ein Verhältnis zwischen der instantanen Magnitude (d.h. der Absolutwert) des Stroms und einem Stromschwellenwert umfassen (zweiter Term der Gleichung oben). |
|  |  | Das Verhältnis ist im Beispiel durch den Faktor 0.01 quantifiziert, aber es sind auch andere Verhältnisse denkbar. |
|  |  | Dies ermöglicht es, solche Strom-Spannung-Wertepaare zu selektieren, die einen möglichst stromfreien Zustand beschreiben. |
|  |  | Die beiden Filterkriterien bilden ein kombiniertes Filterkriterium. Die beiden Filterkriterien gemäß dem ersten und zweiten Term können aber auch getrennt voneinander verwendet werden. |

(fortgesetzt)

|  | Kurze Beschreibung | Beispielhafte Details |
|---|---|---|
| II | Plötzlicher Stromimpuls | $(|dI(k)| > 3 * pI10s(k))$ & $(pI10s(k) < 1C)$<br><br>Ein solches Filterkriterium selektiert Strom-Spannung-Wertepaare, bei denen die aktuelle Stromänderung $dI(k)$ dominant gegenüber dem davor geflossenen zeitlich gemittelten Strom ist. Das ist der erste obige Term.<br><br>Allgemein formuliert bedeutet das also, dass ein Filterkriterium verwendet werden kann, welches ein Verhältnis zwischen der Magnitude der zeitlichen Änderung des Stroms und der zeitgemittelten Magnitude des Stroms umfasst.<br><br>Eine solche Technik ermöglicht es, plötzliche Strompulse zu verwenden, um derart ausgehend von einem relaxiertem Zustand mit einem großen Testpuls ein gutes Signal-zu-Rausch-Verhältnis für die gemessene Spannung zu erhalten.<br><br>Außerdem werden - gemäß dem zweiten Term - solche Strom-Spannung-Wertepaare selektiert, bei dem der zuvor geflossene, zeitlich gemittelte Strom kleiner als ein Grenzwert ist. Der Grenzwert ist 1C, könnte aber auch andere Werte annehmen.<br><br>Daher beschreibt der differentielle Widerstand dR den Hauptanteil der Polarisation zu diesem Zeitpunkt. Die Polarisation beschreibt z.B. Abweichungen vom Ruhepotential aufgrund von Deckschichten, Ladungsdurchtrittsprozessen sowie Diffusionsprozessen.<br><br>Allgemein formuliert wird also ein Filterkriterium verwenden, das ein Verhältnis zwischen der zeitgemittelten Magnitude des Stroms und einem Stromschwellenwert umfasst. Dieser ist im beschriebenen Beispiel in Abhängigkeit von der Kapazität der Batterie bestimmt (C-Rate).<br><br>Aus einem Vergleich der Stromschwellenwerte für die Filterkriterien in I und II ist ersichtlich, dass diese verschieden sind, nämlich einmal fix 0,01 A pro Batteriezelle und einmal relativ definiert in Bezug auf die Kapazität. Als allgemeine Regel können also für unterschiedliche Filterkriterien unterschiedliche Stromschwellenwerte verwendet werden. Es könnten aber auch dieselben Stromschwellenwert verwendet werden. Als allgemeine Regel können absolut definierte Stromschwellenwerte oder relativ definierte Stromschwellenwerte verwendet werden.<br><br>Die beiden Filterkriterien bilden ein kombiniertes Filterkriterium. Die beiden Filterkriterien gemäß dem ersten und zweiten Term können aber auch getrennt voneinander verwendet werden. |

(fortgesetzt)

|  | Kurze Beschreibung | Beispielhafte Details |
|---|---|---|
| III | Zunehmende Stromänderung | $(|dI(k)| > 3 * |dI(k - 1)|)$ & $(pI10s(k) <_{C/2})$ <br><br> Ein solches Filterkriterium bedingt also, dass die derart selektierten Strom-Spannung-Wertepaare eine dominante aktuelle Stromänderung $dI(k)$ beschreiben, und zwar dominant gegenüber der vorherigen Stromänderung $dI(k-1)$. Das ist das Filterkriterium, welches durch den linken Term beschrieben wird. <br><br> Allgemein formuliert berücksichtigt ein solches Filterkriterium also eine zeitliche Änderung der Magnitude der zeitlichen Änderung des Stroms. <br><br> Das Filterkriterium, welches durch den rechten Term beschrieben wird, verlangt, dass der zuvor geflossene Strom kleiner gewesen ist, als ein Stromschwellenwert. Der Stromschwellenwert ist im Beispiel relativ in Bezug auf die Kapazität definiert, könnte aber auch absolut definiert sein. <br><br> Die beiden Filterkriterien bilden ein kombiniertes Filterkriterium. Die beiden Filterkriterien gemäß dem ersten und zweiten Term können aber auch getrennt voneinander verwendet werden. |

Mittels Filterkriterien, wie sie beispielhaft im Zusammenhang mit TAB. 2 diskutiert wurden, wäre es dann also möglich, Strom-Spannung-Wertepaare einer Zeitreihe von Strom-Spannung-Wertepaaren zu erhalten. Für solche Strom-Spannung-Wertepaare in der Teilmenge kann dann ein differentieller Widerstand $dR(k)$ bestimmt werden. Der differentielle Widerstand beschreibt allgemein die Änderung der Spannung in Bezug auf eine (differentiell kleine) Änderung des Stromflusses. Basierend auf diesen differenziellen Widerstand können dann Abschätzungen der Ruhespannung bestimmt werden.

Eine beispielhafte Implementierung ist im Zusammenhang mit der nachfolgenden Gleichung 1 beschrieben:

$$OCV(k) = U(k) - dR(k) \cdot I(k) = U(k) - \frac{dI(k)}{dU(k)}I(k). \qquad (1)$$

Dabei können, als allgemeine Regel, mittels Gleichung 1 unterschiedliche Ruhespannungen bestimmt werden, zum Beispiel eine Entlade-Ruhespannung oder eine Lade-Ruhespannung oder auch eine mittlere Ruhespannung, das heißt gemittelt über die Lade-Ruhespannung und die Entlade-Ruhespannung. Durch Zuordnung der Strom-Spannung-Wertepaare zur Hauptstromrichtung (deren Information durch Magnitudenbildung, d.h. Bildung des Absolutwertbetrags, entfernt wird) können auch sowohl die Entlade-Ruhespannung, wie auch die Lade-Ruhespannung anhand einer Zeitreihe von Strom-Spannung-Wertepaare bestimmt werden, sofern die Zeitreihe sowohl Ladephasen, wie auch Entladephasen abdeckt. Insbesondere wurde beobachtet, dass besonders zuverlässige Werte für die Ruhespannungskennlinie bestimmt werden können, wenn z.B. Fahrtentladung kombiniert mit Rekuperation berücksichtigt wird. Eine besonders genaue Bestimmung der Ruhespannungskennlinie kann insbesondere dann erfolgen, wenn in einem ersten Schritt getrennte Kennlinien für die Entladung und die Ladung bestimmt werden, um derart den Hysterese-Effekt der Ruhespannung zu berücksichtigen. Es wäre dann möglich, diese beiden Ruhespannungskennlinien unter Berücksichtigung des Hysterese-Effekts miteinander zu kombinieren.

Insbesondere kann es also möglich sein, dass für mehrere Strom-Spannung-Wertepaare mehrere Abschätzungen der Ruhespannung für mehrere Ladungszustände der Batterie bestimmt werden. In diesem Zusammenhang könnte für die Bestimmung der Ladungszustände der Ladungs-basierte Ladungszustand mittels Coulomb-Zählen ermittelt werden, d.h. der Ladungsdurchsatz kann überwacht werden. Dies kann auf einer a-priori Abschätzung für die Kapazität beruhen. Das Coulomb-Zählen kann gemäß der Gleichung 2 umgesetzt werden:

$$SOC(k) = SOC(t_0) + \frac{Ah}{C} = 1 + \frac{\int_{t_0}^{t} \eta I(\tau)d\tau}{C} \quad , \qquad (2)$$

wobei $\eta$ eine vorgegebene Coulomb-Effizienz angibt.

Basierend auf den mehreren Abschätzungen für die Ruhespannung kann dann die Ruhespannungskennlinie bestimmt werden. Beispielsweise könnte eine Regression verwendet werden, um die Kurve der Ruhespannungskennlinie an die Abschätzungen für die Ruhespannung bei den mehreren Ladungszuständen anzupassen. Es könnte auch ein Binning verwendet werden. Dabei könnte zum Beispiel ein Mittelwert (etwa: der Median oder das arithmetische Mittel) für alle Werte der Ruhespannung, die innerhalb eines bestimmten Bereichs von Ladungszuständen liegen, gebildet werden. Es könnte auch zwischen unterschiedlichen Ruhespannungen, die bei verschiedenen Ladungszuständen bestimmt wurden, interpoliert werden. In den verschiedenen hierin beschriebenen Beispielen wäre es möglich, dass den Abschätzungen für die Ruhespannung jeweils eine Temperatur zugeordnet wird. Dies bedeutet, dass zusammen mit der Zeitreihe von Strom-Spannung-Wertepaare auch jeweils zugeordnete Temperaturen, zum Beispiel gemessen mit einem Temperatursensor der Batterie (Betriebstemperatur), erhalten werden. Ein Binning kann durchgeführt werden, das heißt es können vordefinierte Temperaturbereiche verwendet werden und die verschiedenen Abschätzungen für die Ruhespannung können dann durch Vergleich der jeweiligen Temperatur mit den vordefinierten Temperaturbereichen einem der Temperaturbereich zugeordnet werden können. Es können dann mehrere Abschätzungen für die Ruhespannungskennlinie bestimmt werden, nämlich für die verschiedenen Temperaturen bzw. Temperaturbereiche. Derart können Effekte der Abhängigkeit der Ruhespannung von der Temperatur kompensiert werden. Eine genauere Abschätzung der Kapazität wird ermöglicht.

Obenstehend wurde eine Technik zur Bestimmung der Abschätzung der Ruhespannungskennlinie beschrieben, welche ein Filtern von Strom-Spannung-Wertepaare kombiniert mit Coulomb-Zählen umfasst. Es können auch andere Techniken zum Bestimmen der Ruhespannungskennlinie eingesetzt werden. Beispielsweise könnte ein maschinengelernter Algorithmus, insbesondere ein rekurrentes neuronales Netzwerk dazu verwendet werden, die Ruhespannungskennlinie zu bestimmen. Beispielsweise kann das rekurrente neuronale Netzwerk als Eingabe die Zeitreihe von Strom-Spannung-Wertepaaren empfangen und als Ausgabe die Ruhespannungskennlinie bereitstellen. Das rekurrente neuronale Netzwerk kann also eine Regressionsschicht aufweisen, die eine Kurve an die Wertepaare der Ruhespannung und der Ladungszuständen anpasst. Diese Regression zur Bestimmung der Kurve der Ruhespannungskennlinie könnte aber auch außerhalb des rekurrenten neuronalen Netzwerks durchgeführt werden, z.B. mittels klassischer Techniken, d.h. z.B. durch Mittelwertbildung oder Fit-Algorithmen.

Basierend auf einer Abschätzung für die Ruhespannungskennlinie ist es dann möglich, eine Abschätzung für die Kapazität der Batterie zu bestimmen. Insbesondere kann in Abhängigkeit von mindestens einem Auslösekriterium eine (a-posteriori) Abschätzung für die Kapazität bestimmt werden. Einige solche Auslösekriterien, die gemäß Beispielen verwendet werden können, sind nachfolgend in TAB. 3 zusammengefasst.

TAB. 3: Unterschiedliche mögliche Auslösekriterien, die dazu verwendet werden können, eine Neuberechnung der Kapazität auszulösen. In den verschiedenen hierin beschriebenen Beispielen ist es möglich, mehrere solche Auslösekriterien miteinander zu kombinieren. Beispielsweise können solche Auslösekriterien in Box 3020 des Verfahrens der FIG. 6 eingesetzt werden.

| | Beispiel | Beispielhafte Details |
|---|---|---|
| I | Konfidenz der Ruhespannungskennlinie | Beim Bestimmen der Abschätzung für die Ruhespannungskennlinie wird eine a-priori Abschätzung für die Kapazität verwendet. Zum Beispiel wird eine solche a-priori Abschätzung im Zusammenhang mit dem Coulomb-Zählen zum Bestimmen des Ladungszustands benötigt. Die a-priori Abschätzung der Kapazität verliert aber mit zunehmender Alterung an Genauigkeit. Dies kann sich in einer größeren Streuung der OCV-SOC-Datenpunkte, die für die Bestimmung der Abschätzung der Ruhespannungskennlinie verwendet werden, ausdrücken. Dies bedeutet, dass die Konfidenz, mit der die Ruhespannungskennlinie bestimmt werden kann, abnimmt. Zum Beispiel eine entsprechende Kurve durch Regression an die Datenpunkte angepasst (ein sog. Kurven-Fit), so kann die Konfidenz von einem entsprechenden Regressionsalgorithmus ausgegeben werden. Die Streuung der Datenpunkte um den Fit ist invers proportional zur Konfidenz. Werden z.B. Mittelwerte für Ladungszustands-Bins gebildet, so könnte eine Streuung berücksichtigt werden. Eine weitere Möglichkeit, um die Konfidenz der Ruhespannungskennlinie zu bestimmen, bestünde darin, den anhand der Ruhespannungskennlinie bestimmten Spannung-basierten Ladungszustand zu vergleichen mit dem zugehörigen Coulomb-Durchsatz, der für die Bestimmung des Ladungs-basierten Ladungszustands verwendet wird; die Stärke der Abweichung zwischen einer 1:1-Korrelation kann die Konfidenz der Ruhespannungskennlinie beschreiben.<br><br>Das bedeutet, dass - mittels solcher und weiterer Techniken - von Zeit zu Zeit die Konfidenz der Ruhespannungskennlinie bestimmt werden kann und in Abhängigkeit von einer entsprechenden Überwachung wahlweise das Verwenden der Abschätzung der Ruhespannungskennlinie zum Bestimmen der Kapazität ausgelöst werden kann, etwa wenn die Konfidenz einem bestimmten Schwellenwert unterschreitet.<br><br>Verschiedene Beispiele beruhen auf der Erkenntnis, dass es ein Optimum für die Konfidenz geben kann. Beispielsweise kann bei vergleichsweise wenigen Datenpunkten, das heißt Wertepaare umfassend die Ruhespannung und einen zugehörigen Ladungszustands, nur mit einer vergleichsweise großen Unsicherheit möglich sein, die Ruhespannungskennlinie zu bestimmen. Das bedeutet, dass die Konfidenz der Ruhespannungskennlinie gering ist. Wenn anschließend mehr Datenpunkte zur Bestimmung der Ruhespannungskennlinie gesammelt werden, so kann die Konfidenz zunächst zunehmen. Ab einem gewissen Zeitpunkt kann aber die Unsicherheit, die mit der Bestimmung der Ladungszustände assoziiert ist, wieder zunehmen. Dies liegt daran, dass die Unsicherheit im Zusammenhang mit der a-priori Abschätzung der Kapazität zunehmen kann. Dies bewirkt im Zusammenhang mit einem Coulomb-Zählen zum Bestimmen der Ladungs-basierten Ladungszustände eine Unsicherheit, auch im Zusammenhang mit der Bestimmung der Ruhespannungskennlinie.<br><br>Dann nimmt die Konfidenz der Ruhespannungskennlinie wieder ab. Das Auslösekriterium kann, ai\|-gemein formuliert, ein solches Optimum berücksichtigen. Dazu kann z.B. die Gültigkeit der a-priori Abschätzung der Kapazität mitberücksichtigt werden, wie nachfolgend beschrieben. |

(fortgesetzt)

| | Beispiel | Beispielhafte Details |
|---|---|---|
| II | Gültigkeit einer a-priori Abschätzung der Kapazität | Die bei der Bestimmung der Abschätzung der Ruhespannungskennlinie verwendete a-priori Abschätzung für die Kapazität kann eine gewisse Gültigkeit aufweisen. Zum Beispiel kann Vorwissen über eine Abhängigkeit der Kapazität vom Alterungszustand der Batterie vorhanden sein. Zum Beispiel könnte Vorwissen über eine Veränderung der Kapazität als Funktion der Betriebsdauer und/oder der Ladezyklen vorhanden sein. Mittels solchen Vorwissens kann dann die Gültigkeit der a-priori Abschätzung der Kapazität bestimmt werden.<br><br>In manchen Beispielen kann insbesondere die Gültigkeit der a-priori Abschätzung der Kapazität der Batterie abhängen vom Wert der Kapazität selbst. Dies liegt daran, dass Alterungseffekte die Kapazität nicht immer linear beeinflussen. Beispielsweise sind sogenannte Klippeneffekte bekannt, bei denen die Kapazität einer Batterie zunächst vergleichsweise wenig stark abnimmt, als Funktion der Zeit und/oder der Ladezyklen; bei fortschreitender Betriebsdauer der Batterie kann dann in den entsprechenden Belastungsintervallen eine vergleichsweise stärkere Abnahme der Kapazität beobachtet werden. Deshalb kann die Gültigkeit der a-priori Abschätzung der Kapazität für eine vergleichsweise junge Batterie länger sein, als für eine ältere Batterie.<br><br>Im Ergebnis bedeutet das, dass eine Bestimmung der a-posteriori Abschätzung der Kapazität für ältere Batterien (aufgrund der verkürzten Gültigkeit der a-priori Abschätzung der Kapazität) häufiger ausgeführt werden kann, als für vergleichsweise neue Batterien (mit großer Kapazität). |
| III | Zeitablauf | Alternativ oder zusätzlich zu solchen Ereignis-ausgelösten Auslösekriterien gemäß Beispiel I oder auch Beispiel II, könnte auch ein zeitabhängiges Auslösekriterien verwendet werden. Zum Beispiel könnte gemäß einem vorgegebenen Zeitplan bestimmt sein, nach welchen Zeitintervallen jeweils eine neue a-posteriori Abschätzung der Kapazität bestimmt wird. |
| IV | Ladungsdurchsatz | Es könnte auch der Ladungsdurchsatz ("Ampere-Stunden-Durchsatz") überwacht werden. Das bedeutet, es könnte gemessen werden, wie viel Ladung durch Laden und Entladen zwischen Anode und Kathode transferiert wird. Wenn ein bestimmter Schwellenwert erreicht wird, kann die Neuberechnung der Kapazität angestoßen werden. |
| V | Zyklen | Als weiteres Auslösekriterium könnte die Anzahl der Ladezyklen berücksichtigt werden. Das bedeutet, es könnte berücksichtigt werden, wie häufig die Batterie zum Beispiel durch Anschluss an eine Netzversorgung geladen wurde. Wird eine bestimmte vorgegebene Anzahl überschritten, so kann dies die Neuberechnung der Kapazität anstoßen. |

EP 4 305 434 B1

Wenn die Ruhespannungskennlinie bestimmt wurde, kann die Ruhespannungskennlinie dazu verwendet werden, eine a-posteriori Abschätzung für die Kapazität zu bestimmen. Dazu könnte z.B. der Ladungszustand Spannungs-basiert aus der Ruhespannungskennlinie bestimmt werden ($SOC_V$); und dann mittels inversem Coulomb-Zählen (d.h. unter Verwendung der Überwachung des Ladungsdurchsatzes für die verschiedenen Ruhespannungen) die a-posteriori Abschätzung der Kapazität ermittelt werden. Die Ruhespannungskennlinie könnte auch im Zusammenhang mit einem Kalman-Filter basierten Verfahren eingesetzt werden. Ein entsprechendes Beispiel ist z.B. beschrieben in Lee, Seongjun, et al. "State-of-charge and capacity estimation of lithium-ion battery using a new open-circuit voltage versus state-of-charge." Journal of power sources 185.2 (2008): 1367-1373.

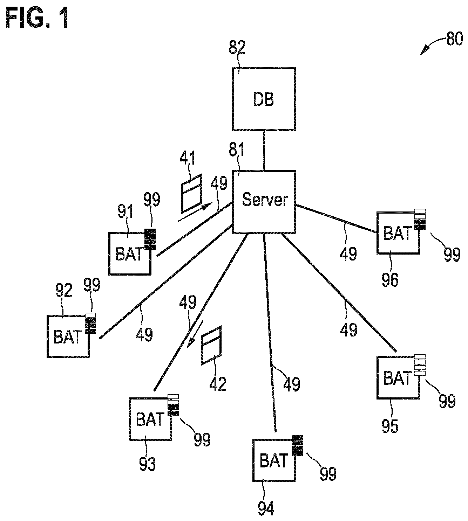

FIG. 1 illustriert Aspekte im Zusammenhang mit einem System 80. Das System 80 umfasst einen Server 81, der mit einer Datenbank 82 verbunden ist. Außerdem umfasst das System 80 Kommunikationsverbindungen 49 zwischen dem Server 81 und jedem von mehreren Batteriesystemen 91-96. Die Kommunikationsverbindungen 49 könnten z.B. über ein Mobilfunknetzwerk implementiert werden. Beispielsweise können die Batteriesysteme 91-96 ein Ensemble bilden, d.h., alle vom gleichen Typ sein. Deshalb können die Batteriesysteme 91-96 gemeinsam überwacht werden, d.h. unter Verwendung derselben Algorithmen.

In FIG. 1 ist beispielhaft illustriert, dass die Batteriesysteme 91-96 über die Kommunikationsverbindungen 49 Zustandsdaten 41 an den Server 81 senden können.

Als konkretes Beispiel könnten zum Beispiel Zustandsdaten empfangen werden, die indikativ sind für physikalische Messwerte der BMS-Funktionalität der BMS-Komponente, zum Beispiel Stromfluss in den Batteriezellen der Energiespeicher-Komponente sowie Spannungen in den Batteriezellen. Das bedeutet, dass die Zustandsdaten 41 indikativ für Strom-Spannung-Wertepaare sein können.

In FIG. 1 ist auch beispielhaft illustriert, dass der Server 81 über die Kommunikationsverbindungen 49 Steuerdaten 42 an die Batterien 91-96 senden kann. Mittels der Steuerdaten wäre es möglich, dass der Server 81 auf Informationen betreffend ein oder mehrere charakteristische Kenngrößen der Batterien 91-96 (cf. TAB. 1), die anhand der Zustandsdaten 41 bestimmt wurden, an die Batterien 91, also z.B. insbesondere an eine BMS-Komponente, sendet. Die BMS-Funktionalität kann dann die Steuerung des Betriebs der jeweiligen Batterie basierend auf den Steuerdaten 42 durchführen.

In FIG. 1 ist für jedes der Batteriesysteme 91-96 schematisch ein Zustandsindikator 99 illustriert. Der Zustandsindikator 99 kann einen Alterungswert der jeweiligen Batterie 91-96 beschreiben. Der Alterungswert könnte z.B. in Abhängigkeit von einer Abschätzung für die Kapazität der jeweiligen Batterie (die mit zunehmender Alterung abnimmt) bestimmt werden. Es werden Techniken beschrieben, um die Kapazität der Batterien 91-96 abzuschätzen.

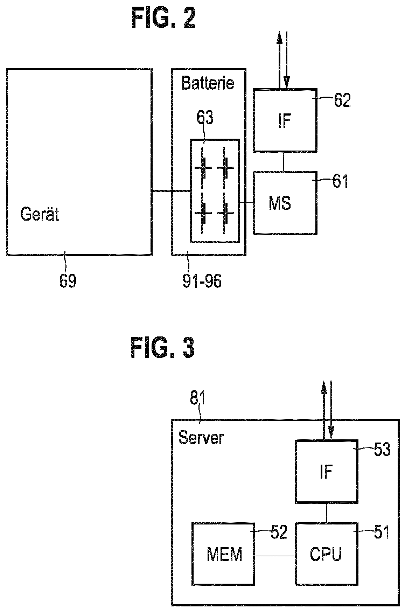

FIG. 2 illustriert Aspekte im Zusammenhang mit den Batterien 91-96. Die Batterien 91-96 sind mit einem jeweiligen Gerät 69 gekoppelt. Dieses Gerät - z.B. ein Elektromotor - wird durch elektrische Energie aus der jeweiligen Batterie 91-96 getrieben. Es stellt also eine elektrische Last dar.

Die Batterien 91-96 umfassen bzw. sind assoziiert mit einem oder mehreren Managementsystemen 61, z.B. ein BMS oder eine andere Steuerlogik wie eine on-boardunit im Falle eines Fahrzeugs. Das Managementsystem 61 kann z.B. durch Software auf einem CPU implementiert sein. Alternativ oder zusätzlich könnte z.B. ein Applikations-spezifischer Schaltkreis (ASIC) oder ein Feldprogrammierbares gated array (FPGA) verwendet werden. Die Batterien 91-96 könnten z.B. über ein Bussystem mit dem Managementsystem 61 kommunizieren. Die Batterien 91-96 umfassen auch eine Kommunikationsschnittstelle 62. Das Managementsystem 61 kann über die Kommunikationsschnittstelle 62 eine Kommunikationsverbindung 49 mit dem Server 81 aufbauen.

Während in FIG. 2 das Managementsystem 61 separat von den Batterien 91-96 gezeichnet ist, wäre es in anderen Beispielen auch möglich, dass das Managementsystem 61 Teil der Batterien 91-96 ist.

Außerdem umfassen die Batterien 91-96 einen oder mehrere Batterieblöcke 63. Jeder Batterieblock 63 umfasst typischerweise eine Anzahl von parallel geschalteten und/oder seriell geschalteten Batteriezellen. Dort kann elektrische Energie gespeichert werden.

Typischerweise kann das Managementsystem 61 auf einen oder mehrere Sensoren in einem oder mehreren Batterieblöcken 63 zurückgreifen. Die Sensoren können z.B. elektrische Kenngrößen der jeweiligen Batterie messen und entsprechende Messwerte bereitstellen, etwa den Stromfluss und/oder die Spannung in zumindest einigen der Batteriezellen. Derart kann eine Zeitreihe von Strom-Spannung-Wertepaaren gemessen werden. Die Sensoren können alternativ oder zusätzlich auch andere Betriebsparameter im Zusammenhang mit zumindest einigen der Batteriezellen messen, beispielsweise Temperatur, Volumen, Druck, etc. Das Managementsystem 61 kann dann eingerichtet sein, um ein oder mehrere solcher Messwerte von Sensoren in Form von Zustandsdaten 41 an den Server 81 zu senden.

FIG. 3 illustriert Aspekte im Zusammenhang mit dem Server 81. Der Server 81 umfasst einen Prozessor 51 sowie einen Speicher 52. Der Speicher 52 kann ein flüchtiges Speicherelement und/oder ein nicht-flüchtiges Speicherelement umfassen. Außerdem umfasst der Server 81 auch eine Kommunikationsschnittstelle 53. Der Prozessor 51 kann über die Kommunikationsschnittstelle 53 eine Kommunikationsverbindung 49 mit jeder der Batterien 91-96 und der Datenbank 82 aufbauen.

Z.B. kann Programmcode im Speicher 52 gespeichert sein und vom Prozessor 51 geladen werden. Der Prozessor 51 kann dann den Programmcode ausführen. Das Ausführen des Programmcodes bewirkt, dass der Prozessor 51 einen oder mehrere der folgenden Prozesse ausführt, wie sie im Zusammenhang mit den verschiedenen Beispielen hierin im Detail beschrieben sind: Bestimmen einer Abschätzung für ein oder mehrere Kenngrößen einer der Batterien 91-96, etwa basierend auf den Zustandsdaten 41; Überwachen von ein oder mehreren Auslösekriterien für das Bestimmen einer a-posteriori Abschätzung für die Kapazität; Bereitstellen der Abschätzungen für die ein oder mehreren Kenngrößen der Batterien 91-96 an die Batterien, z.B. mittels Steuerdaten; usw.

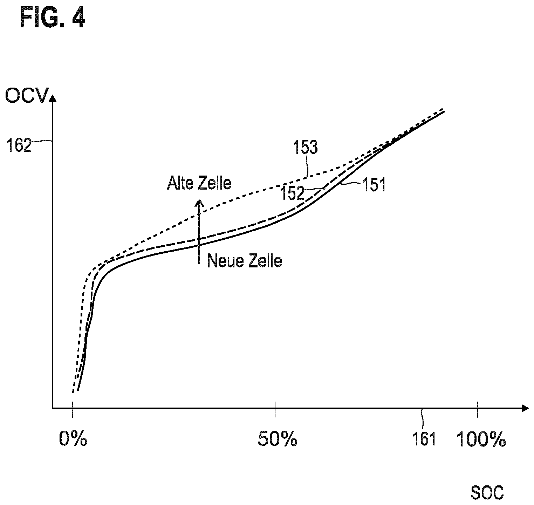

FIG. 4 illustriert Aspekte im Zusammenhang mit Ruhespannungskennlinien 151-153. Die Ruhespannungskennlinien 151-153 indizieren einer Abhängigkeit der Ruhespannung 162 vom Ladungszustand 161. Aus FIG. 4 ist ersichtlich, dass die Ruhespannung 162 für kleinere Ladungszustände abnimmt. In FIG. 4 ist auch die Abhängigkeit der Ruhespannung 162 vom Alterungszustand der jeweiligen Batterie 91-96 dargestellt. Für eine neue Batterie, das heißt eine wenig gealterte Batterie mit großer Kapazität, ergibt sich die Ruhespannungskennlinie 151 (gepunktete Linie) und für gealterte Batterien ergeben sich die Ruhespannungskennlinie 152 und 153 (gestrichelte Linie und durchgezogene Linie; die Ruhespannungskennlinie 152 bezeichnet einen mittleren Alterungszustand; die Ruhespannungskennlinie 153 einen noch weiter gealterten Zustand; der Pfeil illustriert die Tendenz der Veränderung der Ruhespannung für einen Ladungszustand bei zunehmender Alterung). Dabei ist die dargestellte Abhängigkeit aber nur illustrativ; und es sind adere Abhängigkeiten möglich.

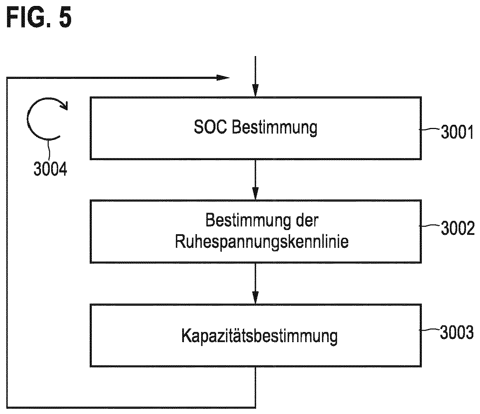

Gemäß verschiedenen Beispielen ist es möglich, die Kapazität der Batterie unter Verwendung der Ruhespannungskennlinie abzuschätzen. Entsprechende Details sind im Zusammenhang mit FIG. 5 beschrieben.

FIG. 5 ist ein Flussdiagramm eines beispielhaften Verfahrens. Das Verfahren der FIG. 5 betrifft Aspekte im Zusammenhang mit der Bestimmung von Abschätzungen für verschiedene charakteristische Kenngrößen einer Batterie. Das Verfahren der FIG. 5 könnte zum Beispiel vom Server 81 ausgeführt werden, beispielsweise vom Prozessor 51 basierend auf Programmcode, der vom Speicher 52 geladen wird.

Gemäß dem dargestellten Beispiel werden iterativ mehrere charakteristische Kenngrößen bestimmt, nämlich hier der Ladungszustand 161 in Box 3001, die Ruhespannungskennlinie 151-153 in Box 3002, sowie die Kapazität in Box 3003.

Die verschiedenen Kenngrößen weisen gegenseitige Abhängigkeiten auf; das heißt zum Beispiel zum Bestimmen des Ladungszustands in Box 3001 kann eine a-priori Abschätzung der Kapazität (beispielsweise aus einer vorangegangenen Iteration 3004 oder als fixer Vorgabewert) verwendet werden. Die Kapazitätsbestimmung in Box 3003 hängt von der Bestimmung des Ladungszustands ab, usw.

Dabei gibt es, als allgemeine Regel, unterschiedliche Möglichkeiten, die verschiedenen Boxen 3001-3003 zu bestimmen. Beispielhafte Möglichkeiten für Boxen 3001 und/oder 3002 sind nachfolgend in TAB. 4 zusammengefasst. Diese Techniken beruhen auf der Verwendung einer Zeitreihe von Strom-Spannung-Wertepaaren.

Tab. 4: Verschiedene Varianten, um Abschätzungen für die Ruhespannung einer Batterie und/oder die Ruhespannungskennlinie der Batterie (das heißt eine Zuordnung der Ruhespannungen zu Ladungszuständen) zu bestimmen.

|  | Kurze Beschreibung | Beispielhafte Details |
|---|---|---|
| I | Differentieller Widerstand | Es ist möglich, unter Verwendung der Gleichung 1 die Ruhespannung basierend auf einer Zeitreihe von Strom-Spannung-Wertepaaren zu bestimmen. Das bedeutet also, dass eine Abschätzung der Ruhespannung basierend auf dem differenziellen Widerstand bestimmt werden kann. Der differentielle Widerstand kann mit dem Stromfluss multipliziert werden und mit der gemessenen Spannung als Bezugswert addiert werden.<br><br>Damit nur relevante Strom-Spannung-Wertepaare berücksichtigt werden, die indikativ für die Ruhespannung sind, kann eine Vorfilterung aller Strom-Spannung-Wertepaare erfolgen. Das wird später z.B. im Zusammenhang mit FIG. 6 beschrieben.<br><br>Gleichzeitig kann es möglich sein, die bestimmten Abschätzungen für die Ruhespannung bestimmten Ladungszuständen 161 der jeweiligen Batterie zuzuordnen. Zum Beispiel könnte der Ladungszustand durch Coulomb-Zählen ermittelt werden. Dazu kann eine a-priori Abschätzung für die Kapazität verwendet werden.<br><br>Aus den Abschätzungen für die Ruhespannung und den zugehörigen Abschätzungen für den Ladungszustand kann dann die Ruhespannungskennlinie bestimmt werden. |

(fortgesetzt)

| | Kurze Beschreibung | Beispielhafte Details |
|---|---|---|
| II | Rekurrentes neuronales Netzwerk | In anderen Beispielen könnte ein rekurrentes neuronales Netzwerk dazu verwendet werden die Abschätzung für die Ruhespannungskennlinie entweder direkt (d.h. Abschätzungen der Ruhespannung in Kombination mit zugehörigen Ladungszuständen) oder, als Zwischenschritt, Abschätzungen für die Ruhespannung ohne Ladungszustand zu bestimmen. In dem letztgenannten Fall könnte mittels herkömmlicher Techniken, zum Beispiel durch Coulomb-Zählen ein jeweils zugehöriger Ladungszustand bestimmt werden. <br><br> Ein rekurrentes neuronales Netzwerk (RNN) kann als Eingabe einen mehrdimensionalen Merkmalsvektor empfangen, wobei unterschiedliche Kanäle mit unterschiedlichen Zeitpunkten assoziiert sind. Dies bedeutet, dass insbesondere Strom-Spannung-Wertepaare für mehrere Zeitpunkte der Zeitreihe als Eingabe an das RNN übergeben werden können. Allgemein kann ein RNN mehrere Schichten aufweisen, wobei auch Rückwärtsverbindungen von Neuronen einer Schicht zu Neuronen von ein oder mehreren vorangegangenen Schichten möglich sind. Direkte oder indirekte Rückkopplungen sind möglich. <br><br> Das RNN kann zum Beispiel durch Verwendung von Trainingsdaten, die von Batterien gleichen Typs eines entsprechenden Ensembles erhalten werden, trainiert werden (vergleiche Ensemble von Batterien 91-96 aus FIG. 1). |

Nachfolgend wird im Zusammenhang mit FIG. 6 ein Beispiel erläutert, welche die Technik gemäß Beispiel I aus TAB. 4 implementiert.

FIG. 6 ist ein Flussdiagramm eines beispielhaften Verfahrens. Das Verfahren aus FIG. 6 dient der Bestimmung einer Abschätzung für die Ruhespannung einer Batterie. Zum Beispiel könnte das Verfahren aus FIG. 6 Box 3001 und zumindest teilweise Box 3002 aus FIG. 5 implementieren. Das Verfahren aus FIG. 6 könnte von einem Server ausgeführt werden, beispielsweise von dem Server 81. Insbesondere könnte das Verfahren aus FIG. 6 vom Prozessor 51 ausgeführt werden, basierend auf Programmcode, der vom Speicher 52 geladen wird.

In Box 3005 wird eine Zeitreihe von Strom-Spannung-Wertepaaren empfangen. Zum Beispiel könnten Zustandsdaten von einer BMS-Funktionalität, die von einer BMS-Komponente der jeweiligen Batterie implementiert wird, empfangen werden (vgl. FIG. 1, Zustandsdaten 41).

Außerdem wird in Box 3010 der Ladungsdurchsatz überwacht. Das bedeutet, dass der Stromfluss zwischen den Klemmen der Batterie über der Zeit integriert werden kann und ins Verhältnis zur Gesamtkapazität gesetzt werden kann. Das wurde im Zusammenhang mit Gleichung 2 obenstehend diskutiert. Derart kann ein Ladungszustand zu den verschiedenen Strom-Spannung-Wertepaaren zugeordnet werden. Dies entspricht einem Ladungs-basierten Ladungszustand $SOC_C$.

In Box 3011 wird überprüft, ob die verschiedenen Strom-Spannung-Wertepaare aus Box 3005 ein oder mehrere Filterkriterien erfüllen. Unter Verwendung dieser ein oder mehreren Filterkriterien kann ein Filtern der Zeitreihe der Strom-Spannung-Wertepaare durchgeführt werden, um derart eine Teilmenge der Strom-Spannung-Wertepaare zu erhalten. Verschiedene Filterkriterien wurden bereits voranstehend im Zusammenhang mit TAB. 2 erläutert. Durch Verwendung der Filterkriterien kann ein besonders genauer Wert für die Abschätzung der Ruhespannung ermittelt werden.

In Box 3015 wird ein Datenpunkt für die spätere Bestimmung der Ruhespannungskennlinie bestimmt. Das bedeutet, dass die Ruhespannung bestimmt werden kann, etwa unter Verwendung der Gleichung 1, über den differenziellen Widerstand. Gleichzeitig kann ein entsprechender Ladungszustand zugeordnet werden, der z.B. mit Gleichung 1 bestimmt wurde.

Dann kann in Box 3020 überprüft werden, ob ein Update für die Abschätzung der Kapazität erforderlich ist. Dazu könnte z.B. bestimmt werden, ob mindestens ein Auslösekriterium (vgl. TAB. 3) erfüllt ist. Hier kann insbesondere berücksichtigt werden, dass die Konfidenz der Ruhespannungskennlinie ein Optimum aufweist. Dieses Optimum kann unter Berücksichtigung der Gültigkeit der a-priori Abschätzung der Kapazität ermittelt werden, wie obenstehend im Zusammenhang mit TAB. 3 beschrieben. Derart kann mit dem Update der Kapazität lang genug gewartet werden, bis die Ruhespannungskennlinie genau genug abgeschätzt werden kann; aber kurz genug mit dem Update der Kapazität gewartet werden, um die Genauigkeit nicht durch eine eingeschränkte Gültigkeit der a-priori Abschätzung der Kapazität und damit der Ladungszustände zu kompromittieren.

Wenn noch kein Update der Kapazität ausgelöst werden soll, können ein oder mehrere weitere Strom-Spannung-Wertepaare der Zeitreihe oder einer weiteren Zeitreihe empfangen werden, in einer weiteren Iteration 3009. Andernfalls kann die Ruhespannungskennlinie bestimmt werden (vergleiche FIG. 5: Box 3002, wo entsprechende Techniken beschrieben wurden). Beispielsweise könnte ein Regression-Fit verwendet werden, um eine entsprechende Kurve an die verschiedenen Datenpunkte anzupassen. Es wäre auch möglich, für mehrere vorgegebene Ladungszustandsintervalle (z.B. 0% bis 5%; 5% bis 10%; 10% bis 15%, usw.; oder z.B. in 1%-Schritten oder 0,5%-Schritten) jeweils basierend auf einer Mittelwertbildung der Ruhespannungen der enthaltenen OCV-SOC-Datenpunkte einen zugehörigen Ruhespannungswert zu ermitteln und damit die Ruhespannungskennlinie zu definieren.

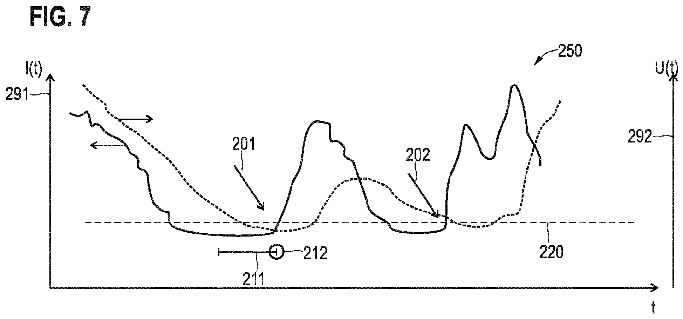

FIG. 7 illustriert Aspekte im Zusammenhang mit einer Zeitreihe 250 von Strom-Spannung-Wertepaare. In FIG. 7 sind die Stromwerte 291 mit der durchgezogenen Linie illustriert und die Spannungswerte 292 sind mit der gepunkteten Linie dargestellt.

FIG. 7 illustriert insbesondere die Verwendung von Filterkriterien, um die Strom-Spannung-Wertepaare zu filtern. Zum Beispiel könnten die Filterkriterien gemäß Beispielen I bis III aus TAB. 2 verwendet werden.

Beispielsweise ist mit dem Pfeil 201 ein Strom-Spannung-Wertepaare hervorgehoben, bei dem die Spannung eine geringe Zeitabhängigkeit aufweist, das heißt das Verhältnis zwischen der zeitlichen Änderung der Spannung und der Spannung selbst kleine Werte annimmt. Außerdem ist gleichzeitig das Verhältnis zwischen der instantanen Magnitude des Stroms 291 und einem Stromschwellenwert 220 kleiner 1. Vergleiche TAB. 2: Beispiel I; dass entsprechende kombinierte Filterkriterium ist hier erfüllt.

Außerdem ist die instantane Änderung des Stromflusses 291 Im Vergleich zur über ein Zeitmittelungsintervall 211 gemittelten Magnitude des Stromflusses 291. Dies entspricht einem plötzlichen Stromimpuls zum Zeitpunkt 212. Vergleiche Tab. 2: Beispiel II.

Entsprechendes gilt auch für das Strom-Spannung-Wertepaare, welches mit dem Pfeil 202 hervorgehoben ist. Dort ist allerdings die Spannung 292 noch nicht vollständig relaxierte, das heißt weist eine zeitliche Änderung auf. Das kombinierte Filterkriterium gemäß Tab. 2: Beispiel I wäre dann nicht erfüllt.

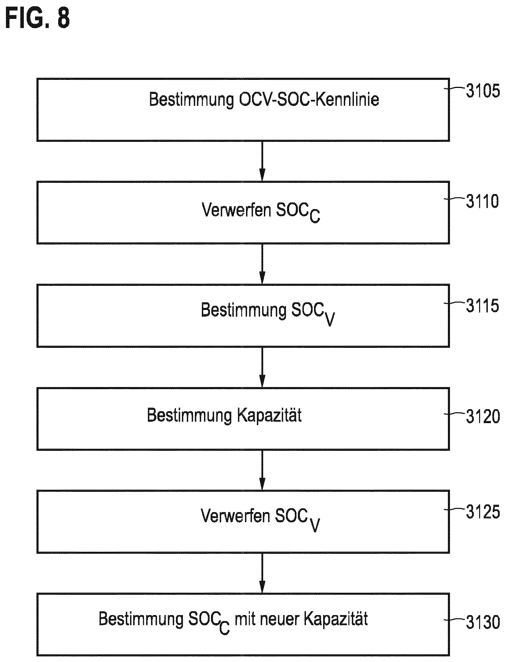

FIG. 8 illustriert ein beispielhaftes Verfahren, welches dazu verwendet werden kann, um die Kapazität abzuschätzen. Das Verfahren der FIG. 8 kann also Box 3002 und Box 3003 der FIG. 5 implementieren.

Zunächst wird in Box 3105 die Ruhespannungskennlinie bestimmt. Insbesondere können die Ladungs-basierten Ladungszustände (SOCc), etwa aus Box 3010, verwendet werden. Es kann ein Fit verwendet werden, um die entsprechende Kurve zu bestimmen. Es wäre auch möglich, jeweils die Ruhespannungen zu mitteln, die zu Ladungszuständen gehören, die in einem jeweiligen vorgegebenen Ladungszustandsintervall ("SOC-Bin") liegen.

In Box 3110 kann die initiale Zuordnung von Ladungszuständen zu Ruhespannungen verworfen werden und können für die Ruhespannungen neue Ladungszustände bestimmt werden. Die Ladungszustände für die verschiedenen Ruhespannungen kann Spannungs-basiert bestimmt werden: SOC=f(OCV). Dazu kann die Ruhespannungskennlinie verwendet werden, die in Box 3105 bestimmt wurde.

In Box 3120 kann anschließend die Kapazität bestimmt werden. Es kann insbesondere ein inverses Coulomb-Zählen angewendet werden. Das bedeutet, dass die Stromflüsse, die mit den verschiedenen Strom-Spannung-Wertepaaren und den nunmehr erneuerten Ladungszuständen assoziiert sind, dazu verwendet werden können, um auf die Kapazität zurück zu schließen.

$$SOC = SOC_R + \frac{Ah}{C}, \tag{3}$$

wobei SOC den Ladungszustand für ein bestimmtes Strom-Spannung-Wertepaar bezeichnet, $SOC_R$ den Referenzladungszustand und Ah der jeweils zugehörige Ladungsdurchsatz ist. C ist die a-posteriori Abschätzung für die Kapazität.

Derart kann also die a-posteriori Abschätzung für die Kapazität bestimmt werden und diese a-posteriori Abschätzung kann dann dazu verwendet werden, um die Ladungs-basierten Ladungszustände in Box 3130 anzupassen (Gleichung 2, mit neuer Kapazität), bzw. die bisherigen Ladungszustände in Box 3125 zu verwerfen.

Das im Zusammenhang mit FIG. 8 beschriebene Verfahren stellt nur eine Möglichkeit dar, um die a-posteriori Abschätzung für die Kapazität zu bestimmen. Es wären auch andere Möglichkeiten denkbar, z.B. ein Kalman-Filter-basiertes Verfahren. Dazu kann die Ruhespannungskennlinie aus Box 3105 verwendet werden, um ein elektrisches Modell, beispielsweise ein Ersatzschaltkreismodell, zu parametrisieren Selbstverständlich können die Merkmale der vorab beschriebenen Ausführungsformen und Aspekte der Erfindung miteinander kombiniert werden. Insbesondere können die Merkmale nicht nur in den beschriebenen Kombinationen, sondern auch in anderen Kombinationen oder für sich genommen verwendet werden, ohne das Gebiet der Erfindung zu verlassen.

Als weiteres Beispiel wurden voranstehend verschiedene Techniken beschrieben, bei denen die Bestimmung von Abschätzungen von ein oder mehreren charakteristischen Kenngrößen einer Batterie Server-seitig auf einem Server stattfindet. Es wäre aber denkbar, dass zumindest manche der Logikoperationen, die hierin beschrieben werden, auch lokal auf Datenverarbeitungseinrichtung in den verschiedenen Batteriesystemen durchgeführt werden, etwa durch eine BMS-Funktionalität der Batterie implementiert.

**Patentansprüche**

1.  Verfahren, das umfasst:

    - Empfangen (3005) einer Zeitreihe (250) von Strom-Spannung-Wertepaaren für einen Strom und eine Spannung einer Batterie (91-96) im Feldbetrieb,
    - unter Verwendung von ein oder mehreren Filterkriterien, Filtern (3011) der Zeitreihe der Strom-Spannung-Wertepaare, um derart eine Teilmenge der Strom-Spannung-Wertepaare zu erhalten, und
    - Bestimmen (3015) von ein oder mehreren Abschätzungen einer Ruhespannung (162) der Batterie (91-96) basierend auf den Strom-Spannung-Wertepaaren in der Teilmenge,
    wobei die ein oder mehreren Filterkriterien ein Verhältnis zwischen einer Magnitude einer zeitlichen Änderung des Stroms (200) und einer zeitgemittelten und/oder instantanen Magnitude des Stroms (200) umfassen, und

    **dadurch gekennzeichnet, dass** die ein oder mehreren Filterkriterien ein Verhältnis zwischen der zeitgemittelten Magnitude des Stroms und einem ersten Stromschwellenwert (220) umfassen, wobei der erste Stromschwellenwert in Abhängigkeit von der Kapazität der Batterie (91-96) bestimmt ist.

2.  Verfahren nach Anspruch 1,
    wobei ein Zeitmittelungsintervall der zeitgemittelten Magnitude des Stroms in Abhängigkeit von einer Temperatur der Batterie bestimmt ist.

3.  Verfahren nach einem der voranstehenden Ansprüche,
    wobei die ein oder mehreren Filterkriterien ein Verhältnis zwischen der instantanen Magnitude des Stroms und einem zweiten Stromschwellenwert umfassen.

4.  Verfahren nach einem der voranstehenden Ansprüche,
    wobei die ein oder mehreren Filterkriterien ein Verhältnis zwischen einer zeitlichen Änderung der Spannung und der Spannung umfassen.

5.  Verfahren nach einem der voranstehenden Ansprüche,
    wobei die ein oder mehreren Filterkriterien eine zeitliche Änderung der Magnitude der zeitlichen Änderung des Stroms umfassen.

6.  Verfahren nach einem der voranstehenden Ansprüche, welches weiterhin umfasst:

    - Bestimmen eines differentiellen Widerstands basierend auf der zeitlichen Änderung des Stroms und einer zeitlichen Änderung der Spannung für die Strom-Spannung-Wertepaare in der Teilmenge,

    wobei die ein oder mehreren Abschätzungen der Ruhespannung basierend auf den Strom-Spannung-Wertepaaren der Teilmenge sowie dem jeweils zugeordneten differentiellen Widerstand bestimmt werden.

7.  Verfahren nach einem der voranstehenden Ansprüche,

    wobei für mehrere Strom-Spannung-Wertepaare der Teilmenge mehrere Abschätzungen der Ruhespannung für mehrere Ladungszustände der Batterie (91-96) bestimmt werden, wobei die mehreren Ladungszustände basierend auf einer a-priori Abschätzung einer Kapazität der Batterie (91-96) und einer Überwachung eines Ladungsdurchsatzes ermittelt werden,
    wobei das Verfahren weiterhin umfasst:

    - Bestimmen einer Abschätzung einer Ruhespannung-Ladungszustands-Kennlinie (151-153) basierend auf den mehreren Abschätzungen der Ruhespannung für die mehreren Ladungszustände.

**Claims**

1.  Method, comprising:

    - receiving (3005) a time series (250) of current-voltage value pairs for a current and a voltage of a battery (91-96) in field operation,

- by using one or a plurality of filter criteria, filtering (3011) the time series of the current-voltage value pairs so as to obtain a subset of the current-voltage value pairs, and

- determining (3015) one or a plurality of estimates of an open-circuit voltage (162) of the battery (91-96) based on the current-voltage value pairs in the subset,

wherein the one or the plurality of filter criteria comprise a ratio between a magnitude of a temporal change of the current (200) and a time-averaged and/or instantaneous magnitude of the current (200), and

**characterised in that** the one or the plurality of filter criteria comprise a ratio between the time-averaged magnitude of the current and a first current threshold value (220), wherein the first current threshold value is determined as a function of the capacity of the battery (91-96).

2. Method according to claim 1,
wherein a time averaging interval of the time-averaged magnitude of the current is determined as a function of a temperature of the battery.

3. Method according to one of the preceding claims,
wherein the one or the plurality of filter criteria comprise a ratio between the instantaneous magnitude of the current and a second current threshold value.

4. Method according to one of the preceding claims,
wherein the one or the plurality of filter criteria comprise a ratio between a temporal change of the voltage and the voltage.

5. Method according to one of the preceding claims,
wherein the one or the plurality of filter criteria comprise a temporal change in the magnitude of the temporal change in the current.

6. Method according to one of the preceding claims, further comprising:

- determining a differential resistance based on the temporal change in current and a temporal change in voltage for the current-voltage value pairs in the subset,

wherein the one or the plurality of estimates of the open-circuit voltage are determined based on the current-voltage value pairs of the subset and the respective associated differential resistance.

7. Method according to one of the preceding claims,
wherein, for a plurality of current-voltage value pairs of the subset, a plurality of open-circuit voltage estimates are determined for a plurality of charge states of the battery (91-96), wherein the plurality of charge states are determined based on an a-priori estimate of a capacity of the battery (91-96) and monitoring of a charge throughput, wherein the method further comprises:

- determining an estimate of an open-circuit voltage-charge state characteristic (151-153) based on the plurality of estimates of the open-circuit voltage for the plurality of charge states.

**Revendications**

1. Procédure comprenant

- réception (3005) d'une série temporelle (250) de paires de valeurs courant-tension pour un courant et une tension d'une batterie (91-96) en fonctionnement sur le terrain,

- en utilisant un ou plusieurs critères de filtrage, filtrage (3011) de la série temporelle des paires de valeurs courant-tension de manière à obtenir un sous-ensemble des paires de valeurs courant-tension, et

- détermination (3015) d'une ou plusieurs estimations d'une tension de repos (162) de la batterie (91-96) sur la base des paires de valeurs de courant-tension dans le sous-ensemble,

dans lequel les un ou plusieurs critères de filtrage comprennent un rapport entre une magnitude d'une variation dans le temps du courant (200) et une magnitude moyennée dans le temps et/ou instantanée du courant (200), et

**caractérisé en ce que** les un ou plusieurs critères de filtrage comprennent un rapport entre la magnitude moyennée dans le temps du courant et un premier seuil de courant (220), le premier seuil de courant étant déterminé en fonction de la capacité de la batterie (91-96).

2. Procédé selon la revendication 1,
dans lequel un intervalle de moyenne temporelle de la magnitude moyennée dans le temps du courant est déterminé en fonction d'une température de la batterie.

3. Procédé selon l'une quelconque des revendications précédentes,
dans lequel les un ou plusieurs critères de filtrage comprennent un rapport entre la magnitude instantanée du courant et un deuxième seuil de courant.

4. Procédé selon l'une quelconque des revendications précédentes,
dans lequel les un ou plusieurs critères de filtrage comprennent une relation entre une variation dans le temps de la tension et la tension.

5. Procédé selon l'une quelconque des revendications précédentes,
dans lequel les un ou plusieurs critères de filtrage comprennent une variation dans le temps de la magnitude de la variation dans le temps du courant.

6. Procédé selon l'une quelconque des revendications précédentes, comprenant en outre :

   - détermination d'une résistance différentielle basée sur la variation dans le temps du courant et une variation dans le temps de la tension pour les paires de valeurs courant-tension dans le sous-ensemble,

dans lequel les une ou plusieurs estimations de la tension de repos sont déterminées sur la base des paires de valeurs de courant-tension du sous-ensemble ainsi que de la résistance différentielle respectivement associée.

7. Procédé selon l'une quelconque des revendications précédentes,

   dans lequel, pour une pluralité de paires de valeurs de courant-tension du sous-ensemble, une pluralité d'estimations de la tension de repos sont déterminées pour une pluralité d'états de charge de la batterie (91-96), la pluralité d'états de charge étant déterminée sur la base d'une estimation a priori d'une capacité de la batterie (91-96) et d'une surveillance d'un débit de charge,
   le procédé comprenant en outre :

   - détermination d'une estimation d'une caractéristique tension de repos-état de charge (151-153) sur la base de la pluralité d'estimations de la tension de repos pour la pluralité d'états de charge.

# FIG. 1

**FIG. 2**

**FIG. 3**

# FIG. 4

# FIG. 5

```
        ┌──────────────────────────────────────┐
        │            SOC Bestimmung            │──3001
        └──────────────────────────────────────┘
3004                    │
                        ▼
        ┌──────────────────────────────────────┐
        │           Bestimmung der             │──3002
        │        Ruhespannungskennlinie        │
        └──────────────────────────────────────┘
                        │
                        ▼
        ┌──────────────────────────────────────┐
        │         Kapazitätsbestimmung         │──3003
        └──────────────────────────────────────┘
```

# FIG. 6

3001, 3002

Empfange Strom-Spannung-Wertepaare — 3005

3009

Überwachung des Ladungsdurchsatzes — 3010

N — Filterkriterium erfüllt? — 3011

J

Bestimme OCV-SOC-Datenpunkt — 3015

Kapazität Update? — 3020

J

N

**FIG. 7**

# FIG. 8

| | |
|---|---|
| Bestimmung OCV-SOC-Kennlinie | —3105 |
| ↓ | |
| Verwerfen $SOC_C$ | —3110 |
| ↓ | |
| Bestimmung $SOC_V$ | —3115 |
| ↓ | |
| Bestimmung Kapazität | —3120 |
| ↓ | |
| Verwerfen $SOC_V$ | —3125 |
| ↓ | |
| Bestimmung $SOC_C$ mit neuer Kapazität | —3130 |

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2020152901 A1
- DE 102013000572 A1
- WO 2020262655 A1
- WO 2019240270 A1
- DE 102010051008 A1
- DE 102016209852 A1

**In der Beschreibung aufgeführte Nicht-Patentliteratur**

- **MATHIAS** ; **MICHAEL A. DANZER**. Advancements in OCV measurement and analysis for lithium-ion batteries.. *IEEE Transactions on energy conversion*, 2013, vol. 28 (3), 675-681
- **B. ZHANG** ; **CAIPING et al.** A generalized SOC-OCV model for lithium-ion batteries and the SOC estimation for LNMCO battery.. *Energies*, 2016, vol. 9 (11), 900
- **TONG** ; **SHIJIE** ; **MATTHEW P. KLEIN** ; **JAE WAN PARK**. On-line optimization of battery open circuit voltage for improved state-of-charge and state-of-health estimation. *Journal of Power Sources*, 2015, vol. 293, 416-428
- **CHEN** ; **XIAOKAI et al.** A novel approach to reconstruct open circuit voltage for state of charge estimation of lithium ion batteries in electric vehicles. *Applied Energy*, 2019, vol. 255, 113758
- **XIONG** ; **RUI** ; **QUANQING YU** ; **CHENG LIN**. A novel method to obtain the open circuit voltage for the state of charge of lithium ion batteries in electric vehicles by using H infinity filter. *Applied energy*, 2017, vol. 207, 346-353
- **LEE** ; **SEONGJUN et al.** State-of-charge and capacity estimation of lithium-ion battery using a new open-circuit voltage versus state-of-charge.. *Journal of power sources*, 2008, vol. 185 (2), 1367-1373